# EUROPEAN PATENT APPLICATION

(11) **EP 1 306 900 A2**
(43) Date of publication of application: **02.05.2003**
(21) Application number: 01000785.4
(22) Date of filing: 20.12.2001
(51) Int. Cl.: H01L 23/538, H01L 25/10

(54) **Chip-scale packages stacked on folded interconnector for vertical assembly on substrates**

(30) Priority: 28.12.2000 US 258525
(71) Applicant: Texas Instruments Incorporated, Dallas, Texas 75251 (US)
(72) Inventor: Morrison, Gary P., Garland, TX 75044 (US); Edwards, Darvin R., Garland, TX 75044 (US); Stark, Leslie, Dallas, TX 75214 (US)
(74) Representative: Holt, Michael

(57) **Abstract**

A vertical stack of semiconductor devices 140, 141 is formed by folding a strip-like flexible interconnector 101 assembled with integrated circuit chips 130, 133, packages and/or passive components and attaching coupling members 107 solderable to other parts.

## Description

### FIELD OF THE INVENTION

The present invention is related in general to the field of semiconductor devices and processes, and more specifically to structure and processes of chip-scale packages stacked onto interconnecting film for vertical assembly onto substrates.

### DESCRIPTION OF THE RELATED ART

It is advantageous for many applications of semiconductor devices to arrange the needed devices in close proximity, even in a cluster. When only two, or few more, semiconductor chips are needed, various arrangements have been proposed in order to achieve the desired proximity, and to enable a minimization of required space. Typically, these arrangements are assemblies of semiconductor chips on a substrate, with or without a specific encapsulation. For these arrangements, the term "multichip module" is commonly used. For an encapsulated assembly, the term "multichip package" has been introduced. In other assemblies, chips or completed packages are stacked on top of each other to form a hierarchy of interconnected devices.

For many years, there has been a rather limited market for multichip modules and multichip packages or stacked devices, but driven by the rapidly expanding penetration of integrated circuit applications, this market is recently growing significantly in size. In order to participate in this market, though, the multichip products have to meet several conditions.
* The multichip product has to offer the customer performance characteristics not available in single-chip products. This means, the multichip product has to leapfrog the development of single-chip product.
* The multichip product has to be available to the customer at short notice. This means, the multichip product should use readily available components and fabrication methods.
* The multichip product has to offer the customer a cost advantage. This means, the design and fabrication of the multichip product has to avoid unconventional or additional process steps.
* The multichip product has to offer low cost-of-ownership. This means, it has to operate reliably based on built-in reliability.

Numerous multichip packages have been described in publications and patents. For instance, U.S. Patent No. 4,862,322, Aug. 29, 1989 (Bickford et al.) entitled "Double Electronic Device Structure having Beam Leads Solderlessly Bonded between Contact Locations on each Device and Projecting Outwardly from Therebetween" describes a structure of two chips facing each other, in which the input/output terminals are bonded by beam leads. The high cost, however, of materials, processing and controls never allowed the beam lead technology to become a mainstream fabrication method.

In U.S. Patent No. 5,331,235, Jul. 19, 1994 (H.S. Chun) entitled " Multi-Chip Semiconductor Package", tape- automated bonding plastic tapes are used to interconnect two chips of identical types, facing each other, into pairs. One or more of these pairs are then assembled into an encapsulating package, in which the plastic tapes are connected to metallic leads reaching outside of the package to form the leads or pins for surface mount and board attach. The high cost of the plastic tapes and the lack of batch processing kept the technology of tape-automated bonding at the margins of the semiconductor production.

Several proposals have been made of multichip devices in which two or more chips are arranged side by side, attached to a supporting substrate or to leadframe pads. An example is U.S. Patent No. 5,352,632, Oct. 4, 1994 (H. Sawaya) entitled "Multichip Packaged Semiconductor Device and Method for Manufacturing the Same". The chips, usually of different types, are first interconnected by flexible resin tapes and then sealed into a resin package. The tapes are attached to metallic leads which also protrude from the package for conventional surface mounting. Another example is U.S. Patent No. 5,373,188, Dec. 13, 1994 (Michii et al.) entitled "Packaged Semiconductor Device including Multiple Semiconductor Chips and Cross-over Lead". The chips, usually of different types, are attached to leadframe chip pads; their input/output terminals are wire bonded to the inner lead of the leadframe. In addition, other leads are used under or over the semiconductor chips in order to interconnect terminals which cannot be reached by long-spanned wire bonding. Finally, the assembly is encapsulated in a plastic package. In both of these examples, the end products are large, since the chips are placed side by side. In contrast, today's applications require ever shrinking semiconductor products, and board consumption is to be minimized.

U.S. Patent No. 5,438,224, Aug. 1, 1995 (Papageorge et al.) entitled "Integrated Circuit Package having a Face-to-Face IC Chip Arrangement" discloses an integrated circuit (IC) package with a stacked IC chip arrangement placed on a circuit substrate. Two chips are positioned face to face, with a substrate made of tape-automated bonding tape or flex circuit interposed between the chips to provide electrical connection among the terminals of the flip chip and external circuitry; a separate mechanical support is needed for the assembly. In addition to this cost, fabrication is difficult due to the lack of rigid support for the chips.

U.S. Patent No. 5,770,480, Jun. 23, 1998 (Ma et al.) entitled "Method of Leads between Chips Assembly" increases the IC density by teaching the use of leadframe fingers to attach to the bond pads of multiple chips employing solder or conductive bumps. While in the preferred embodiments both chips of a set are identical in function, the method extends also to chips with differing bond pad arrangements. In this case, however, the leadframe needs customized configuration and non-uniform lengths of the lead fingers, especially since the use of bond wires is excluded. The manufacture of these so-called variable-leads-between-chips involves costly leadframe fabrication equipment and techniques. In addition, a passivation layer is required, to be disposed between the two chips and the customized lead fingers, in order to prevent potential electrical shorts, adding more material and processing costs.

U.S. Patent # 6,084,778, Jul. 4, 2000 (Malhi, "Three-dimensional Assembly using Flexible Wiring Board"), to which the present invention is related, describes a flexible strip having an interconnect pattern thereon and a plurality of electrical components coupled to the interconnect. The flexible printed wiring board is folded back upon itself to provide a three-dimensional circuit. The patent, however, does not address the need to transform the fine-pitch pad pattern of chip-size packages to the typical larger pitch desired for solder ball attachment to other parts, nor does it provide for integrated circuit devices which use the flexible interconnector as part of their package design.

In two recent U.S. Patent Applications, # 60/172,186, filed 12/17/1999 (Rolda et al., "Multi-Flip-Chip Semiconductor Assembly"), and # 60/249,385, filed 11/ 16/2000 (Coyle et al., "Flip-Chip on Film Assembly for Ball Grid Array Packages"), to which the present invention is related, flip-chip assembly techniques have been described for typical pitch using solder balls to fine pitch using gold bumps. These approaches, however, are still too expensive in product assembly as well as cost-of-ownership. Cost has recently become the dominant driving force in the semiconductor marketplace, especially for products using chip-scale devices.

An urgent need has therefore arisen for a coherent, low-cost method of fabricating multichip packages based on available, proven assembly and encapsulation techniques. The method should be flexible enough to be applied for different semiconductor product families and a wide spectrum of design and process variations, should add no additional cost to the existing fabrication methods, and deliver high-quality and high-reliability products. Preferably, these innovations should be accomplished while shortening production cycle time and increasing throughput.

### SUMMARY OF THE INVENTION

A vertical stack of semiconductor devices is formed by folding a strip-like flexible interconnector assembled with integrated circuit chips, packages and/or passive components and attaching coupling members solderable to other parts.

The invention describes a semiconductor assembly comprising a strip-like flexible interconnector of electrically insulating material having first and second surfaces. The interconnector has on its first surface electrically conductive lines for connecting a plurality of semiconductor devices formed on the first surface adjacent to each other. The interconnector further has electrically conductive paths extending from its first surface to its second surface, forming electrical ports on the second surface. The ports comprise first and second pluralities, the first plurality ports spaced apart by less, center to center, than said second plurality ports are spaced apart, center to center.

The interconnector is folded so that said adjacent semiconductor devices are stacked on top of each other. The assembly comprises at least one additional semiconductor device, which has a plurality of first electrical coupling members, with these first coupling members attached to the first plurality ports. Finally, a plurality of second electrical coupling members is attached to the second plurality ports and these coupling members are suitable for attachment to other parts.

While the invention is applicable to devices of any size, a preferred embodiment comprises devices of small geometries such as chip-scale and chip-size packages.

In another preferred embodiment, the flexible interconnector enables the transition from the fine-pitch land pads for the attached discreet devices to the customer-desired pitch for the solderable coupling members. The discreet devices include fine-pitch, bumped chip-scale packages and fine-pitch flipped, bumped chips.

It is an aspect of the present invention to provide a low-cost method and system for assembling high pin-count chip-scale devices in thin overall profile.

Another aspect of the present invention is to provide a high production throughput by employing multiple footprint techniques for active and passive components.

Another aspect of the invention is to improve electrical product performance by minimizing parasitic resistances and inductances.

Another aspect of the invention is to provide high quality control and reliability assurance through in-process control at no extra cost.

Another aspect of the invention is to introduce assembly concepts for thin profiles and reliability which are flexible so that they can be applied to many families of semiconductor products, and are general so that they can be applied to several future generations of products.

Another aspect of the invention is to minimize the cost of capital investment and the movement of parts and product in the equipment.

These aspects have been achieved by the teachings of the invention concerning design concepts and process flow suitable for mass production. Various modifications have been successfully employed to satisfy different selections of product geometries and materials.

A first embodiment of the invention combines two single or dual-chip packages with passive components, or with multiple fine-pitch chip-scale packages, or with multiple bumped and flipped chips.

A second embodiment of the invention combines three single or dual-chip packages with a third package, which has been fabricated and tested separately.

A third embodiment of the invention combines three single or dual-chip packages with passive components, or with multiple fine-pitch chip-scale packages, or multiple bumped and flipped chips.

A fourth embodiment of the invention combines three single or dual-chip packages. The invention further provides for a variety of other different combinations.

The technical advances represented by the invention, as well as the objects thereof, will become apparent from the following description of the preferred embodiments of the invention, when considered in conjunction with the accompanying drawings and the novel features set forth in the appended claims.

### BRIEF DESCRIPTION OF THE DRAWINGS

FIG. I1A is a schematic top view of the partially assembled interconnector according to System and Flow I of the invention.

FIG. I1B is a schematic cross section of the partially assembled interconnector according to System and Flow I of the invention.

FIG. I1C is a schematic bottom view of the partially assembled interconnector according to System and Flow I of the invention.

FIG. I2 is a schematic cross section of the partially assembled interconnector in the process of folding, according to System and Flow I of the invention.

FIG. I3A is a schematic cross section of a plurality of fine-pitch chip-scale packages prepared for attachment onto the folded interconnector of FIG. I2.

FIG. I3B is a schematic cross section of a plurality of integrated circuit chips prepared for attachment onto the folded interconnector of FIG. I2.

FIG. I4A is a schematic cross section of the fully assembled vertical device stack including the fine-pitch chip-scale packages of FIG. I3A.

FIG. I4B is a schematic cross section of the fully assembled vertical device stack including the integrated circuit chips of FIG. I3B, with optional underfilling and/or encapsulation.

FIG. II1A is a schematic top view of the partially assembled interconnector according to System and Flow II of the invention.

FIG. II1B is a schematic cross section of the partially assembled interconnector according to System and Flow II of the invention.

FIG. II1C is a schematic bottom view of the partially assembled interconnector according to System and Flow II of the invention.

FIG. II2 is a schematic cross section of the partially assembled interconnector in the process of folding, according to System and Flow II of the invention.

FIG. II4A is a schematic cross section of the fully assembled vertical device stack including two packages and passive components.

FIG. II4B is a schematic cross section of the fully assembled vertical device stack including a third package, which has bee fabricated and tested separately.

FIG. II4C is a schematic cross section of the fully assembled vertical stack including three packages and passive components.

FIG. II4D is a schematic cross section of the fully assembled vertical stack including three packages assembled on opposite surfaces of the interconnector.

FIG. II4E is a schematic cross section of the fully assembled vertical stack illustrating an additional example of assembly options provided by the invention.

### DETAILED DESCRIPTION OF THE PREFERRED EMBODIMENTS

Structures and methods according to the invention are described in two examples: System and Flow I are illustrated in FIGs. I1A through I4B; System and Flow II are illustrated in FIGs. II1A through II4E.

For System & Flow I, FIG. I1A shows schematically the top view of a rectangular strip-like interconnector 101. It is made of electrically insulating material which is flexible. A preferred choice is a polyimide film in the thickness range from about 40 to 80 µm; in some instances, it may be thicker. Given enough flexibility, other suitable materials include PCB resin, FR-4 (which is an epoxy resin), or a cyanate ester resin. These materials are commercially available from several sources; in the U.S.A., companies include 3-M and Sheldahl; in Japan, Shinko, Shindo, Sumitomo, and Mitsui; and in Hongkong, Compass. This interconnector has two surfaces; FIG. I1C depicts, in bottom view, the first surface 102, while FIG. I1A depicts, in top view, the second surface 103.

Integral with the interconnector 101 is a plurality of electrically conductive lines 104 (they are depicted, as an example, in the top view of FIG. I1A). These conductive lines 104 are usually patterned from a thin metal foil, preferably between about 15 and 40 µm thick. Suitable materials include copper, copper alloys, gold, silver, palladium, platinum, and stacked of nickel/gold and nickel/ palladium. These conductive lines form on the first surface 102 a first array of electrical entry ports 105 and a second array of exit ports 106. As FIG. I1C shows, these arrays are grouped in separate areas of the interconnector; the entry ports 105 are actually depicted in multiple arrays.

It is important for the present invention that the entry ports 105 are spaced apart by less, center to center, than the exit ports 106 are spaced apart, center to center. While the present invention can be applied to any pitch of the entry or exit ports, preferably, these fine-pitched entry ports 105 are spaced apart from each other by less than 100 µm center to center. In contrast, the relatively wide-pitched exit ports 106 are typically spaced apart considerably more than 100 µm center to center. Since the exit ports 106 provide the attachment sites for the coupling members to other parts, their convenient spacing satisfies a desire often expressed by customers, namely to be provided with solder ball attachment sites convenient for semiconductor board assembly. Frequently, the exit ports 106 provide a common footprint to industry standards for chip-scale packages.

Entry ports 105 are typically made of copper, often with a protective flash of gold. Exits ports 106 have to be solderable and thus have to insure reliable wetting. They may be covered by layers of a refractory metal (such as chromium, molybdenum, titanium, tungsten, or titanium/ tungsten alloy) and a noble metal (such as gold, palladium, platinum or platinum-rich alloy, silver or silver alloy).

For some products using System & Flow I, and for System & Flow II, the interconnector also has electrically conductive paths extending through the interconnector from one surface to the opposite surface. The mechanical flexibility of such interconnectors also helps preventing solder ball cracking under mechanical stress due to thermal cycling. As stated above, the interconnector is preferably made of compliant material, such as tape, Kapton™ film, polyimide, or other plastic material, and may contain single or multiple layers of patterned conductors. In this fashion, the flexibility of the base material provides a stress buffer between the thermally mismatched semiconductor chip and the P.C. board, and will relieve some of the strain that develops in the chip solder balls in thermal cycling. Alternatively, an interconnector may be made of epoxies, FR-4, FR-5, or BT resin.
Interconnectors with conductive through-paths are commercially available; for instance Novaclad® and ViaGrid® from Sheldahl, Inc., Northfield, MN. They are typically fabricated by laminating alternative films of electrically insulating and electrically conducting materials into one coherent layer. Connections through individual insulating films are made by laser drilling and metal refilling or plating, and patterning of the conductive films is achieved by ablation or etching. There are numerous designs and variations of interconnectors available.

In the schematic cross section of FIG. I1B, the exit ports on the first surface 102 of the interconnector are depicted as having solder balls 107 attached as coupling members for attachment to other (outside) parts. These solder balls are selected from a group consisting of pure tin, tin alloys including tin/copper, tin/indium, tin/silver, tin/ bismuth, tin/lead, and conductive adhesive compounds.

As used herein, the term solder "ball" does not imply that the solder contacts are necessarily spherical; they may have various forms, such as semispherical, half-dome, truncated cone, or generally bump, or a cylinder with straight, concave or convex outlines. The exact shape is a function of the deposition technique (such as evaporation, plating, or prefabricated units) and reflow technique (such as infrared or radiant heat), and the material composition. Several methods are available to achieve consistency of geometrical shape by controlling amount of material and uniformity of reflow temperature. Typically, the diameter of the solder balls ranges from 0.1 to 0.5 mm, but can be significantly larger.

Further shown in the top view of FIG. I1A are encapsulated devices 108; they are depicted in cross section in FIG. I1B. Examples for such devices are MicroStar ™ Ball Grid Arrays (BGAs) and MicroStarJunior™ packages fabricated by Texas Instruments Incorporated, Dallas, Texas, U.S.A. These devices comprise integrated circuit (IC) chips attached to the interconnector film, wire bonding and transfer molded packages.

The electrically conductive lines 104 indicated in FIG. I1A may contain at least one passive electrical component (not shown in FIG. I1A) integrated into the conductive lines. Examples include resistors, capacitors, inductors, distributed components, and networks of passive components and interconnected structures. Fabrication methods for these integrated components have recently been described in U.S. Patent Application # 60/244,673, filed on 10/31/2000 (Pritchett et al., "Plastic Chip-Scale Package having Integrated Passive Components"), which is herewith incorporated by reference.

As indicated in FIG. I2, the flexible interconnector strip 101 is folded at the region 120 of the integrated conductive lines between the adjacent areas of the entry ports and exit ports. The folding is such that the entry ports face in one direction while the exit ports face in the opposite direction. As a consequence of this folding, the package bodies 108 touch each other, resulting in a vertically stacked assembly having approximately the outline of a chip-scale package. If desired, they package bodies can be glued together in order to render the tight stacking permanent.

FIGs. I3A and I3B illustrate how the entry ports can be populated with semiconductor devices. FIG. I3A depicts, in schematic cross section, multiple chip-scale devices 130, packaged in an encapsulation 131 and having a plurality of fine-pitch electrical coupling members 132. These coupling members may consist of solder "balls" made of pure tin, a tin alloy as listed above, or a conductive adhesive compound. The pattern of the coupling members 132 is mirror-imaging the pattern of the interconnector entry ports.

As indicated in FIG. I4A, the fine-pitch coupling members 132 of chip-scale devices 130 are attached by surface mounting to the entry ports of the interconnector 101. The result is an assembly of chip-scale packages, generally designated 140, stacked vertically and having a plurality of coupling members 107 suitable for attachment to other, outside parts.

Alternatively, FIG. I3B depicts, in schematic cross section, multiple un-encapsulated IC chips 133, prepared for flip-chip assembly by having a plurality of fine-pitch electrical coupling members 134. These coupling members may consist either of solder "balls" (made of pure tin, tin alloys as listed above, or a conductive adhesive compound) or of metal bumps selected from a group consisting of gold, copper, copper alloy, or layered copper/nickel/palladium. Another option is z-axis conductive epoxy. The bumps have various shapes, for example rectangular, square, round, or half-dome. For metal bumps, the method of attaching the coupling members 134 to the entry ports of the interconnector is a thermo-compression bonding technique based on metal interdiffusion, as has been practiced previously in the tape-automated-bonding (TAB) fabrication method. The preferred technique for the present invention is a gang-bonding technique for array assembly. This technique has the advantage of fast and low-cost operation while resulting in high quality, reliable attachments. The automated apparatus is commercially available from Shinkawa Corporation, Japan.

FIG. I4B shows as the result an assembly, generally designated 141, of flipped chips 133 and encapsulated devices 108, stacked vertically; the assembly further has a plurality of coupling members 107 suitable for attachment to other, outside parts.

FIG. I4A shows that the packages 131 of devices 130 are spaced apart from the interconnector 101 by gaps 142. The solder balls 132 extend across the gaps, connecting to the interconnector. It is an advantage of this invention to choose the materials so that the significant difference in the coefficient of thermal expansion (CTE) between the semiconductor material of the IC chips and the material typically used for the interconnector can be minimized. It is, therefore, usually not necessary in the assembly of FIG. I4A to strengthen the solder joints (without affecting the electrical connection) by filling the gap 142 with a polymeric material which encapsulates the bumps and fills any space in the gap between the package and the interconnector ("underfilling" method).

This method of underfilling may, however, be appropriate for the assembly depicted in FIG. I4B. This underfilling material, together with some encapsulating material, is indicated by the schematic outline 142 in FIG. I4B. The encapsulant is typically applied after completion of the assembly. A polymeric precursor, sometimes referred to as the "underfill", is dispensed onto the substrate adjacent to the chip and is pulled into the gap by capillary forces. Typically, the polymeric precursor comprises an epoxy-based material filled with silica and anhydrides. The precursor is then heated, polymerized and "cured" to form the encapsulant. The underfilling method preferred by this invention has been described in U.S. Patent Application # 60/084,440, filed on 05/06/98 (Thomas, "Low Stress Method and Apparatus of Underfilling Flip-Chip Electronic Devices").

For System & Flow II, FIG. II1A shows schematically the top view of a rectangular strip-like interconnector 201, FIG. II1B its cross section, and FIG. II1C the bottom view. The descriptions for materials, processes, conductive lines 204, exit ports 206, optional integrated passive electrical components, solder balls 207, and packaged devices 208 are analogous to the descriptions in FIGs. I1A, I1B, and I1C. The significant difference is depicted in FIGs. II1B and II1C by the discreet passive components 210 attached to the first surface 202 of the interconnector 201. Consequently, the pattern of the entry ports in FIG. II1C is significantly simplified compared to the pattern in FIG. I1C. It is not specifically highlighted in FIG. II1C; it is implicit in the customized attachment the passive components 210.

Similarly, the folding of flexible interconnector strip 201 at the region 220 of the integrated conductive lines between adjacent areas of the entry and exit ports, as illustrated in FIG. II2, is analogous to the folding of interconnector 101 in FIG. I2. As a consequence of this folding, the package bodies 208 touch each other, resulting in a vertically stacked assembly having approximately the outline of a chip-scale package. If desired, they package bodies can be glued together in order to render the tight stacking permanent.

The result is illustrated in FIG. II4A. It is an assembly, generally designated 240, of chip-scale packages 208 and discreet passive electrical components 210 stacked vertically and having a plurality of coupling members 207 (usually solder balls) suitable for attachment to other parts. This assembly in FIG. II4A, like the analogous assemblies in FIGs. I4A and I4B, represents an example of the fist embodiment of this invention:
- FIGs. I4A, I4B, and II4A: A first embodiment of the invention combines two single or dual-chip packages (up to four chips total) with passive components, or with multiple fine-pitch chip-scale packages, or with multiple bumped and flipped chips.
- FIG. II4B: A second embodiment of the invention combines three single or dual-chip packages (up to six chips total) with a third package, which has been fabricated and tested separately.
- FIG. II4C: A third embodiment of the invention combines three single or dual-chip packages (up to six chips total) with passive components, or with multiple fine-pitch chip-scale packages, or multiple bumped and flipped chips.
- FIG. II4D: A fourth embodiment of the invention combines three single or dual-chip packages (up to six chips total). The invention further provides for a variety of other different combinations.
- FIG. II4E: The invention further provides for a variety of other different combinations. The product is a vertical stack of approximately chip- scale footprint, composed of a plurality of active and passive electrical components and devices.

While this invention has been described in reference to illustrative embodiments, this description is not intended to be construed in a limiting sense. Various modification and combinations of the illustrative embodiments, as well as other embodiments of the invention, will be apparent to persons skilled in the art upon reference to the description. As an example, the material of the semiconductor chip may comprise silicon, silicon germanium, gallium arsenide, or any other semiconductor material used in manufacturing. It is therefore intended that the appended claims encompass any such modifications or embodiments.

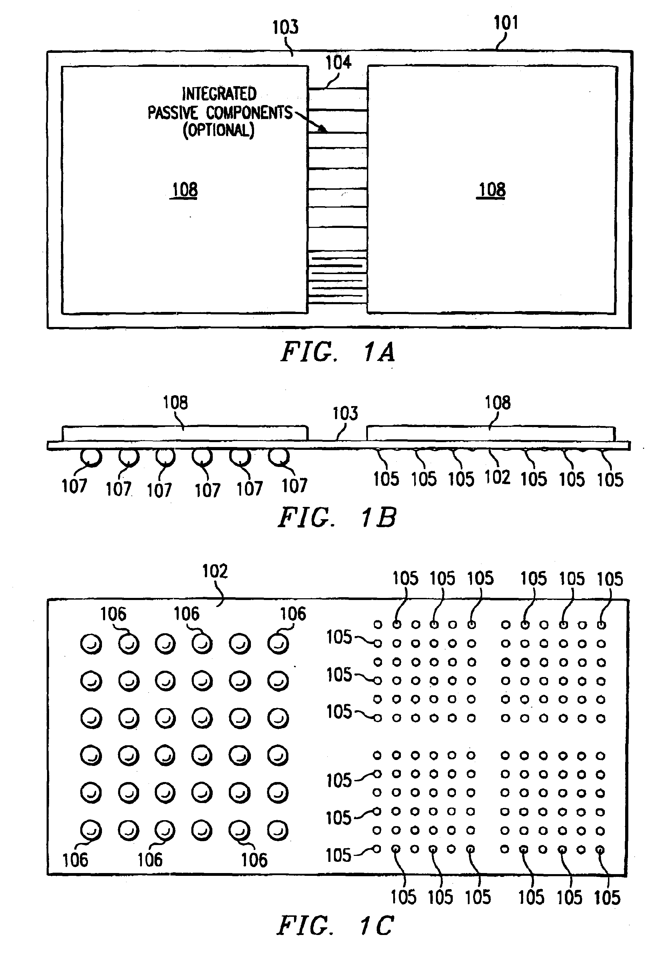

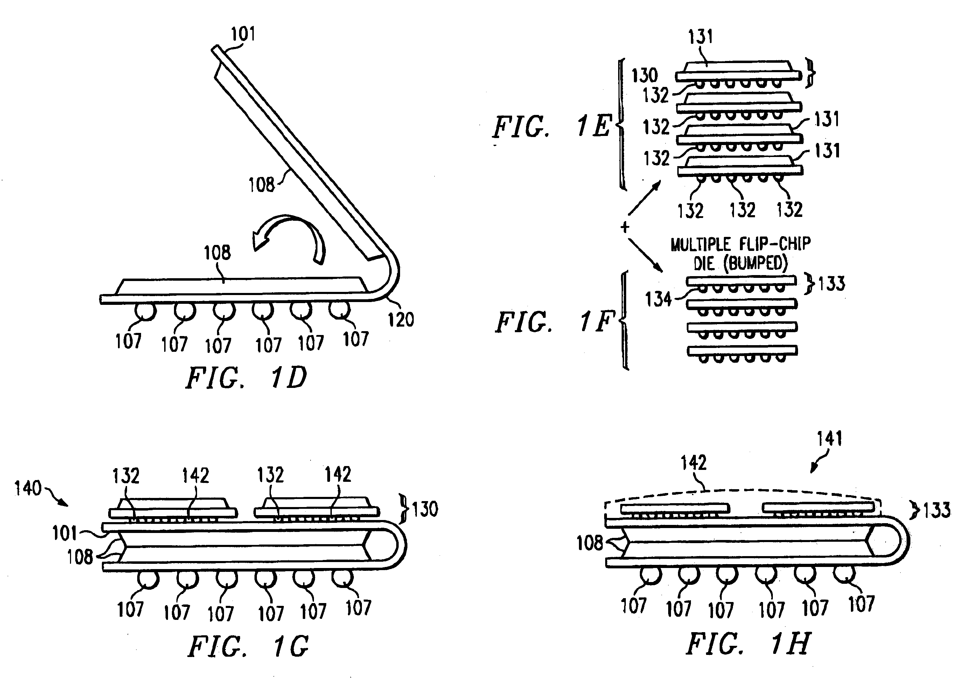

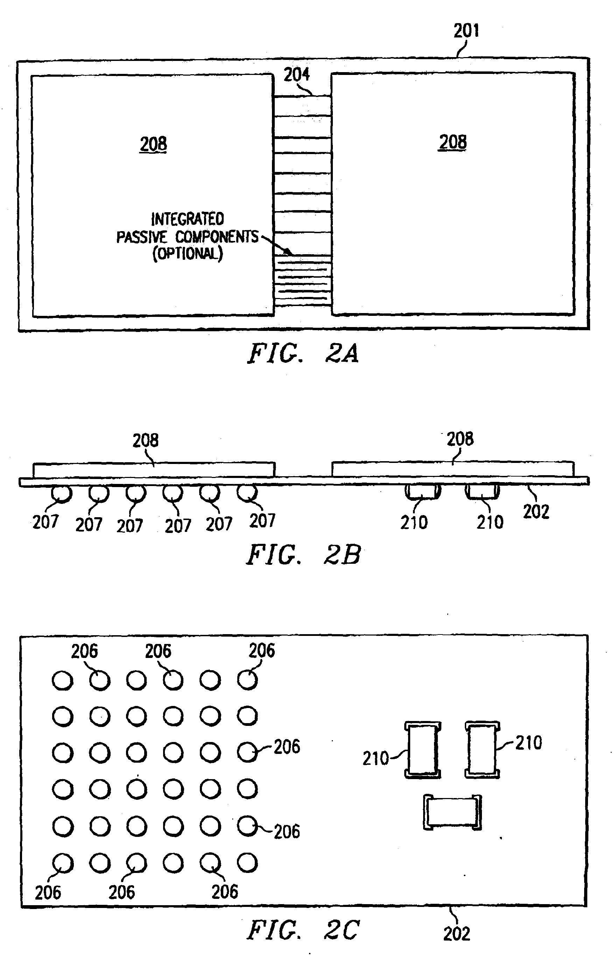

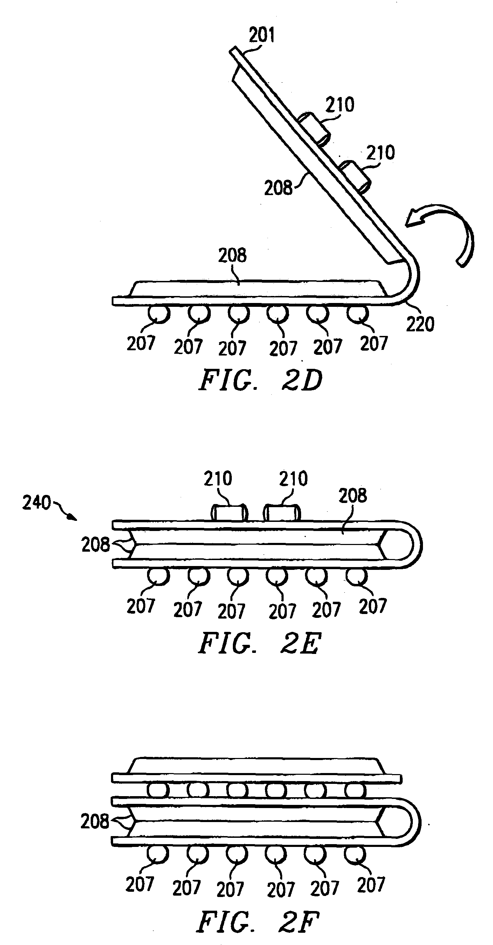

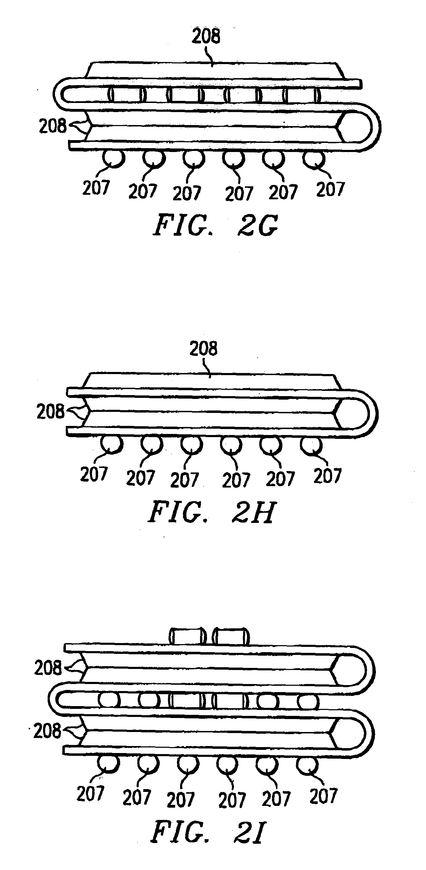

## Claims

1. A semiconductor assembly comprising:
a strip-like flexible interconnector of electrically insulating material having first and second surfaces;
electrically conductive lines integral with said interconnector, forming on said first surface a first array of electrical entry ports and a second array of exit ports, said arrays grouped in separate areas of said interconnector;
said entry ports spaced apart by less, center to center, than said exit ports are spaced apart, center to center;
said interconnector folded so that said entry ports face in one direction while said exit ports face in the opposite direction;
at least one semiconductor device having a plurality of first electrical coupling members, said first coupling members attached to said entry ports; and
a plurality of second electrical coupling members attached to said exit ports, said second coupling members suitable for attachment to other parts.

2. The assembly according to Claim 1 wherein said semiconductor device is an integrated circuit chip having an active and a passive surface, said first coupling members attached to said active surface.

3. The assembly according to Claim 1 wherein said semiconductor device is an integrated circuit chip encapsulated in a package with outside contact pads, said first coupling members attached to said contact pads.

4. The assembly according to Claim 1 further comprising at least one passive electrical component integrated into said conductive lines on said interconnector.

5. The assembly according to Claim 1 wherein said entry ports are spaced apart less than 100 µm center to center, and said exit ports are spaced apart more than 100 µm center to center.

6. The assembly according to Claim 1 wherein said interconnector is a flexible polyimide film.

7. The assembly according to Claim 1 wherein said electrically conductive lines are made of a material selected from a group consisting of copper, copper alloy, or copper plated with tin, tin alloy, silver, or gold.

8. The assembly according to Claim 1 wherein said first and second coupling members are solder balls selected from a group consisting of pure tin, tin alloys including tin/copper, tin/indium, tin/silver, tin/bismuth, tin/lead, and conductive adhesive compounds.

9. The assembly according to Claim 1 wherein said first coupling members are selected from a group consisting of gold bumps, copper bumps, copper/nickel/palladium bumps, and z-axis conductive epoxy.

10. The assembly according to Claim 1 further having an adhesive non-conductive polymer underfilling any spaces between said first coupling members attached to said entry ports under said semiconductor device.

11. A semiconductor assembly comprising:
a strip-like flexible interconnector of electrically insulating material having first and second surfaces;
said interconnector having on said first surface electrically conductive lines for connecting a a plurality of semiconductor devices formed on said first surface adjacent to each other;
said interconnector further having electrically conductive paths extending through said interconnector from said first surface to said second surface, forming at least one array of electrical ports on said second surface;
said interconnector folded so that said adjacent semiconductor devices are stacked on top of each other; and
a plurality of electrical coupling members attached to said ports, said coupling members suitable for attachment to other parts.

12. The assembly according to Claim 11 further comprising at least one discreet passive electrical component attached to said ports.

13. The assembly according to Claim 11 further comprising at least one semiconductor device attached to said ports.

14. The assembly according to Claim 11 further comprising at least one passive electrical component integrated into said conductive lines on said interconnector.

15. A semiconductor assembly comprising:
a strip-like flexible interconnector of electrically insulating material having first and second surfaces;
said interconnector having on said first surface electrically conductive lines for connecting a plurality of semiconductor devices formed on said first surface adjacent to each other;
said interconnector further having electrically conductive paths extending through said interconnector from said first surface to said second surface, forming electrical ports on said second surface;
said ports comprise first and second pluralities, said first plurality ports spaced apart by less, center to center, than said second plurality ports are spaced apart, center to center;
said interconnector folded so that said adjacent semiconductor devices are stacked on top of each other;
at least one additional semiconductor device having a plurality of first electrical coupling members, said first coupling members attached to said first plurality ports; and
a plurality of second electrical coupling members attached to said second plurality ports, said coupling members suitable for attachment to other parts.

16. A method of assembling an integrated circuit device, comprising the steps of:
forming electrically conductive lines on a strip-like flexible interconnector of electrically insulating material having first and second surfaces;
forming on said first surface a first array of electrical entry ports and a second array of exit ports, said arrays grouped in separate areas of said interconnector, said entry ports spaced apart by less, center to center, than said exit ports are spaced apart, center to center;
attaching at least one semiconductor device having a plurality of first electrical coupling members to said entry ports;
attaching a plurality of second electrical coupling members to said exit ports; and
folding said interconnector so that said entry ports face in one direction while said exit ports face in the opposite direction.

17. The method according to Claim 16 further comprising the step of:
integrating at least one passive electrical component into said conductive lines on said interconnector.

18. The method according to Claim 16 further comprising the step of:
underfilling an adhesive non-conductive polymer into any spaces between said first coupling members attached to said entry ports under said semiconductor device.

19. A method of assembling an integrated circuit device, comprising the steps of:
forming electrically conductive lines on a strip-like flexible interconnector of electrically insulating material having first and second surfaces;
forming electrically conductive paths extending through said interconnector from said first surface to said second surface, forming at least one array of electrical ports on said second surface;
forming on said first surface a plurality of semiconductor devices adjacent to each other and connected to said conductive lines;
attaching a plurality of electrical coupling members to said ports; and
folding said interconnector so that said adjacent semiconductor devices are stacked on top of each other.

20. The method according to Claim 19 further comprising the step of:
attaching at least one discreet passive electrical component to said ports.

21. The method according to Claim 19 further comprising the step of:
attaching at least one semiconductor device to said ports.

22. The method according to Claim 19 further comprising the step of:
integrating at least one passive electrical components into said conductive lines on said interconnector.

23. A method of assembling an integrated circuit device, comprising the steps of:
forming electrically conductive lines on a strip-like flexible interconnector of electrically insulating material having first and second surfaces;
forming electrically conductive paths extending through said interconnector from said first surface to said second surface, forming electrical ports on said second surface such that said ports comprise first and second pluralities, said first plurality ports spaced apart less, center to center, than said second plurality ports are spaced apart, center to center;
forming on said first surface a plurality of semiconductor devices adjacent to each other and connected to said conductive lines;
attaching at least one additional semiconductor device, having a plurality of first electrical coupling members, to said first plurality ports;
attaching a plurality of second electrical coupling members to said second plurality ports; and
folding said interconnector so that adjacent semiconductor devices are stacked on top of each other.
